# FASCICULE DE BREVET EUROPEEN

(11) **EP 3 124 655 B1**
(45) Date de publication et mention de la délivrance du brevet: **12.09.2018**
(21) Numéro de dépôt: 16180805.0
(22) Date de dépôt: 22.07.2016
(51) Int. Cl.: C25D 17/00, C25D 17/06, H01L 21/67

(54) **DISPOSITIF DE SUPPORT ADAPTABLE POUR SUBSTRATS A TRAITER NOTAMMENT PAR VOIE CHIMIQUE OU ELECTROCHIMIQUE**
ANPASSBARE HALTEVORRICHTUNG FÜR SUBSTRATE, DIE INSBESONDERE CHEMISCH ODER ELEKTROCHEMISCH BEHANDELT WERDEN SOLLEN
ADAPTABLE SUPPORTING DEVICE FOR SUBSTRATES TO BE TREATED IN PARTICULAR CHEMICALLY OR ELECTROCHEMICALLY

(30) Priorité: 31.07.2015 FR 1557373
(43) Date de publication de la demande: 01.02.2017
(73) Titulaire: SILIMIXT, 37270 Larcay (FR)
(72) Inventeur: VENTURA, Laurent, 37000 Tours (FR); DESPLOBAIN, Sébastien, 37270 Larçay (FR)

(56) Documents cités:
- EP-A1- 0 597 428
- FR-A1- 2 315 028
- US-A1- 2006 103 830

## Description

L'invention concerne notamment le domaine du traitement chimique et électrochimique de substrats en vue de gravures ou de dépôts de matière.

L'invention est plus particulièrement relative à un dispositif de support pour un ou plusieurs substrats conducteurs ou semi-conducteurs et destinés à subir un traitement électrochimique, le dispositif de support comprenant des moyens périphériques d'étanchéité.

Le traitement électrochimique est couramment utilisé dans la structuration de surfaces conductrices ou semi-conductrices en vue de nombreuses applications, notamment dans le domaine de la micro-électronique, ou relatives à la fabrication de capteurs, électrodes, membranes filtrantes, microdiffuseurs, réflecteurs optiques ou thermiques, supports d'isolation thermique ou électrique etc...

Dans le cadre des semi-conducteurs, on peut citer la texturation de plaquettes de silicium. L'invention sera plus particulièrement décrite en regard de cette application, sans toutefois y être limitée.

Une technique connue pour réaliser un traitement électrochimique est de placer le substrat à traiter dans un bain d'électrolyte comprenant une électrode placée à distance du substrat, le substrat étant destiné à constituer une seconde électrode. L'électrode et le substrat sont connectés à deux polarités respectives opposées, le substrat formant anode ou cathode selon qu'il s'agit respectivement d'un enlèvement ou dépôt de matière.

Une autre technique connue consiste à placer le substrat entre deux bains d'électrolyte distincts comprenant chacun une électrode placée à distance du substrat, la circulation du courant d'électrolyse entre les deux électrodes étant forcée au travers du substrat. Une étanchéité entre les deux bains et entre les deux faces opposées du substrat est alors impérative.

Aujourd'hui, le dispositif de mise en oeuvre d'un procédé de traitement par bain(s) électrolytique(s) comprend un bâti présentant une cavité remplie d'une solution électrolytique, un porte-plaquette qui accueille le substrat à traiter, nommé encore plaquette, et qui est disposé dans la solution d'électrolyte. Une fois le porte-plaquette accueillant le substrat mis en place, celui-ci délimite deux bains dans la solution électrolytique (les deux bains pouvant contenir la même solution ou deux solutions différentes), qu'il convient par ailleurs de rendre étanche l'un par rapport à l'autre. A cet égard, des moyens d'étanchéité sont prévus entre le porte-plaquette et le bâti.

En outre, des moyens d'étanchéité sont prévus au sein même du porte-plaquette et agencés de manière à circonscrire les surfaces des deux faces de la plaquette, en particulier la face de la plaquette destinée à être traitée chimiquement ou électro-chimiquement.

Le porte-plaquette et les diverses étanchéités porte-plaquette/bâti et porte-plaquette/substrat ont donc pour rôle de séparer les deux solutions électrolytiques et de pouvoir polariser différemment les deux faces opposées du substrat.

Plus particulièrement, la plupart des porte-plaquettes sont généralement composés de deux parties amovibles qui prennent en sandwich la plaquette. Chaque partie présente intérieurement une surface plane entourant une ouverture centrale. Les ouvertures des deux parties du porte-plaquette sont destinées à être mises en regard et délimitent la surface de la zone de la plaquette qui sera à traiter, le pourtour de la plaquette étant prise intégralement en sandwich sur une distance la plus faible possible (quelques millimètres voire moins si possible) de manière à réduire le plus possible la surface non traitée de la plaquette. Des moyens d'étanchéité périphériques sont logés dans une gorge du porte-plaquette. Lorsque les deux parties du porte-plaquette sont refermées sur la plaquette, les moyens d'étanchéité sont ainsi comprimés contre les deux faces opposées du substrat à traiter et selon son contour périphérique, assurant ainsi une étanchéité entre les deux faces opposées de la plaquette.

Un tel dispositif connu présente certains inconvénients, notamment :
- La mise en place et le retrait d'une plaquette prise en sandwich à l'intérieur du porte-plaquette prennent du temps du fait de devoir séparer/remonter les deux parties du porte-plaquette, qui sont généralement associées par vissage, ce qui ne favorise pas une mise en oeuvre industrielle.
- La zone à traiter est limitée à l'ouverture traversante du porte-plaquette ; or le porte-plaquette recouvre une portion parfois non négligeable de la bordure de la plaquette, réduisant de fait la possibilité de traitement dans cette région ;
- Lors du démontage, après la séparation des deux parties, la plaquette repose encore sur l'une des deux parties du porte-plaquette et peut parfois rester collée par capillarité d'où la nécessité de la décoller du moyen d'étanchéité avant de pouvoir la manipuler puis la déplacer.

Au regard des moyens d'étanchéité entre le substrat et le porte-plaquette, la demande de brevet européen EP0597428 propose des moyens d'étanchéité aptes à se déformer sous l'effet d'un gaz introduit dans lesdits moyens de sorte à ajuster la surface d'appui des moyens d'étanchéité contre la tranche du substrat en limitant avantageusement a minima le recouvrement de la surface à traiter.

L'invention a donc pour but de proposer un nouveau dispositif de support de substrat à traiter notamment électro-chimiquement, doté de moyens d'étanchéité, qui est amélioré par rapport au dispositif du document précité, s'avère simple et rapide de mise en oeuvre, en particulier permettant un montage rapide et aisé de plusieurs tailles et formes de substrats, qui garantisse un maintien ferme du substrat à porter et une étanchéité efficace tout en maximisant la surface à traiter du substrat et qui garantisse un démontage rapide et sans effort du substrat.

D'autres avantages seront également mis en avant, tels que traiter plusieurs substrats à la fois, et/ou contrôler le traitement, en particulier contrôler la porosification du chant du substrat de manière symétrique ou dissymétrique.

Selon l'invention, le dispositif de support d'au moins un substrat à traiter électro-chimiquement, comprend :
- un support doté d'au moins une ouverture traversante, l'ouverture étant destinée à accueillir un substrat à traiter, et s'étendant dans un plan général qui est destiné à être parallèle au plan de la ou des surfaces à traiter,
- au moins un joint d'applique accueilli dans un logement du support, s'étendant selon un périmètre encerclant l'ouverture, et destiné à s'appliquer contre le substrat lorsque ce dernier est logé dans l'ouverture,
- des moyens déformables gonflables pour assurer au joint d'applique d'exercer des forces de compression de direction transversale au chant du cadre du support et dirigées vers l'ouverture, de sorte à appuyer le joint d'applique contre le chant du substrat, et
est caractérisé en ce que les moyens déformables gonflables sont distincts du joint d'applique et sont constitués d'au moins un élément déformable gonflable disposé autour dudit joint d'applique, à l'opposé de l'ouverture.

Le joint d'applique est non gonflable.

Ainsi, l'élément déformable gonflable coopère avec le joint d'applique en étant apte à lui transmettre des forces de compression pour son serrage contre le substrat. Le joint d'applique est passif en subissant les forces de compression de l'élément déformable gonflable. Ces forces de compression sont transmises en direction du joint d'applique qui les transmet à son tour transversalement au chant du cadre du support en direction de l'ouverture logeant le substrat, c'est-à-dire que pour un cadre à paroi par exemple annulaire, les forces de compression sont radiales et dirigées vers le centre de l'ouverture. Ainsi, lorsqu'un substrat est positionné à l'intérieur d'une ouverture, le joint d'applique comprimé par l'élément déformable est apte à transmettre des forces de compression contre la tranche du substrat, dans des plans parallèles aux faces planes du substrat.

La présente invention se distingue de l'art antérieur par la présence d'un élément déformable gonflable venant comprimer le joint d'applique en contact avec le substrat. Cette coopération offre des avantages supplémentaires, au contraire de la compression pneumatique directe par un joint d'applique unique se déformant.

Dans l'art antérieur, le serrage est assuré par la mise sous pression pneumatique du joint d'applique de type « tubeless » (expression anglaise couramment employée en français pour désigner un joint à chambre creuse sans chambre à air), ce qui ne permet pas son remplacement aisé pour s'adapter à différentes formes de substrats, contrairement à l'utilisation du joint d'applique indépendant de l'élément gonflable de la présente invention. D'autre part l'utilisation d'un élément gonflable indépendant, ledit élément gonflable comprenant une chambre fermée, évite tout risque d'infiltration d'électrolyte ou de vapeur d'électrolyte dans le circuit pneumatique quelle que soit la position de serrage ou de repos du joint d'applique, à la différence d'un serrage par compression d'un joint d'applique directement poussé par un gaz.

Cette réalisation de l'invention, où un élément gonflable agit sur un joint d'applique non gonflable, permet de maîtriser plus facilement l'homogénéité du serrage sur tout le pourtour du substrat sans risque de l'abîmer, notamment au regard de la grandeur des forces de compression et de la répartition de ces forces.

Le joint d'applique est aisément amovible sans démonter le support.

L'élément gonflable comporte une chambre creuse apte à être remplie de fluide sous pression pour l'expansion dudit élément.

Le dispositif peut comporter, de préférence dans le même support, plusieurs ouvertures destinées chacune à accueillir un substrat à traiter, chaque ouverture étant dotée en périphérie d'un logement comprenant un joint d'applique pour coopérer avec un substrat, le dispositif comprenant au moins un élément déformable gonflable apte à coopérer par compression tout autour de chaque joint d'applique, de préférence l'élément gonflable étant logé également dans ledit support.

Les ouvertures dans le support délimitent des cadres qui accueillent chacun un substrat. Le substrat sera maintenu par son joint d'applique lorsque l'élément déformable gonflable exercera sa compression.

Ainsi, une ouverture du support est délimitée par un cadre dont le chant comporte sur la totalité de sa périphérie, une gorge logeant le joint d'applique qui est apte à transmettre des forces de compression, exercées par l'élément déformable gonflable, de direction transversale au chant du cadre du support et dirigées vers l'ouverture.

Deux variantes définissent l'état de l'élément gonflable en l'absence de substrat. L'élément déformable gonflable, en l'absence de substrat, est :
- soit à l'état dégonflé ou peu gonflé, c'est-à-dire suffisamment rétracté pour ne pas exercer une compression sur le joint d'applique, le substrat peut alors être mis en place dans l'ouverture puis il est nécessaire de gonfler l'élément (pressuriser l'élément en injectant un fluide sous pression dans le corps creux de l'élément), pour que l'élément gonflable se dilate et engendre des forces de compression contre le joint d'applique qui à son tour coopère avec le chant du substrat par contact intime pour ainsi assurer l'étanchéité ;
- soit à l'état gonflé en appui contre le joint d'applique ; il est alors nécessaire de dépressuriser l'élément gonflable pour qu'il se rétracte et cesse d'exercer une compression sur le joint d'applique de façon à pouvoir insérer le substrat, puis de relâcher la dépressurisation dans l'élément gonflable afin qu'il se détende et comprime à nouveau le joint d'applique de sorte à s'appuyer contre le chant du substrat réalisant l'étanchéité.

La mise en compression des joints d'applique par les éléments gonflables, selon l'une des deux variantes précédentes, entraîne simultanément une étanchéité parfaite par compression:
i. entre lesdits éléments gonflables et les parois intérieures du support logeant lesdits éléments gonflables,
ii. entre lesdits éléments gonflables et les chants externes desdits joints d'applique (chants opposés aux substrats),
iii. entre les chants internes desdits joints d'applique et les chants des substrats,

La mise en compression des joints d'applique par les éléments déformables qui sont à l'état expansé assure le maintien des substrats, tandis que le relâchement de la pression (par arrêt de gonflage ou par dépressurisation) dans les éléments gonflables entraîne la libération simultanée de la pluralité de substrats par rétractation desdits éléments gonflables.

Dans un mode de réalisation préféré, la pluralité d'ouvertures est agencée dans un seul plan, les logements étant disposés les uns à côtés des autres dans un unique support.

Une ouverture du support délimite un cadre dont le chant est doté d'une gorge logeant un joint d'applique, le chant interne du joint d'applique (destiné à être en regard du substrat) présentant un profil correspondant à la forme géométrique du pourtour du substrat.

Le joint d'applique est avantageusement monobloc, c'est-à-dire configuré d'un seul tenant, en une seule partie.

Dans un mode de réalisation préféré l'élément déformable gonflable est unique pour plusieurs joints d'applique et présente une forme et une longueur adaptées pour courir d'un seul tenant autour de chaque joint d'applique tandis qu'une pluralité de joints d'applique est prévue pour une pluralité d'ouvertures.

En variante, le dispositif comporte plusieurs éléments déformables gonflables, avec un élément déformable gonflable associé à chaque joint d'applique.

De préférence, l'élément déformable est déformable par mise en pression/dépressurisation pneumatique. Il est apte à exercer un serrage par expansion.

L'élément déformable gonflable est en un matériau étanche et élastique, et est de type joint gonflable à chambre fermée ou de type tuyau gonflable, de façon que ledit élément gonflable soit destiné à coopérer hermétiquement avec le joint d'applique par compression.

Le volume du logement accueillant l'élément gonflable est adapté, en particulier est tel que l'élément gonflable présente un volume plus faible que le volume du logement lorsque l'élément gonflable n'est pas sollicité pour engendrer une mise en compression du joint d'applique. Ainsi, dans le cas de la première variante, l'élément gonflable présente un volume plus faible que le volume du logement lorsque qu'aucune pression pneumatique n'est appliquée dans la chambre dudit élément gonflable, de façon que la mise en surpression pneumatique de la chambre dudit élément gonflable entraîne une expansion de volume dudit élément et une mise en compression du joint d'applique. Dans le cas de la seconde variante, l'élément gonflable présente un volume plus faible que le volume de la cavité lorsqu'une dépressurisation est effectuée dans la chambre dudit élément gonflable, de façon qu'une remise en pression atmosphérique à l'intérieur de ladite chambre entraîne une expansion de volume dudit élément et une mise en compression du joint d'applique.

L'élément déformable est destiné à coopérer avec un système de mise en compression/dépressurisation, de préférence un système pneumatique, qui procure un serrage/desserrage (pneumatique) garantissant un montage/démontage rapide du substrat de son cadre/ de son support et un maintien en position ferme et fiable du substrat, tout en garantissant l'étanchéité recherchée.

L'élément déformable gonflable est par exemple un joint creux du type à section unitaire fermée et doté d'un orifice d'échappement, ou du type à ligne ouverte et comprenant deux extrémités libres, l'orifice d'échappement ou les extrémités libres étant aptes à être raccordés à des moyens de mise en pression ou de dépressurisation pneumatique.

Chaque ouverture est apte à recevoir un substrat par amenée à plat du substrat dans le plan général de l'ouverture (par amenée selon une direction sensiblement transversale au plan d'ouverture), et par applique du chant du substrat au niveau du joint d'applique, le substrat étant mis en butée contre des moyens de calage solidaires du support ou du joint d'applique, et les moyens de calage étant agencés dans un plan décalé et parallèle à l'ouverture. L'amenée du substrat et son agencement se font donc très simplement sans qu'il soit besoin d'ouvrir en deux le support ou de dissocier le joint d'applique en deux parties, comme dans l'art antérieur pour introduire le substrat par sa tranche coplanairement au joint à la manière d'une insertion par guillotine.

En outre, un avantage supplémentaire est de pouvoir disposer le support tout aussi bien verticalement que horizontalement. Lorsque le support est à l'horizontal, le substrat est amené en étant déposé par gravité sur les moyens de calage, le joint entourant directement le substrat tout comme pour un support vertical.

Selon une autre caractéristique, le dispositif comporte ainsi des moyens de calage qui sont destinés à assurer le maintien en position du substrat de manière coplanaire au joint d'applique par application d'au moins une face du substrat contre lesdits moyens de calage, avant le serrage par la déformation de l'élément déformable.

De manière préférée, les moyens de calage de la présente invention sont solidaires (du corps) du support. En variante, les moyens de calage peuvent également être solidaires du joint d'applique, lui-même destiné à épouser le chant du substrat, via un profil adapté. Par exemple, le profil du joint d'applique peut comporter un décrochement ou une lèvre en saillie permettant une insertion directe à plat parallèlement au plan d'ouverture du support et un calage du substrat dans le plan de l'ouverture du support, ce que ne permet pas les support de l'art antérieur.

Par les moyens de calage de la présente invention, l'association de la plaquette au support (porte-plaquette), par conséquent le montage/démontage, est bien plus simple que dans l'art antérieur où il est nécessaire de démonter le porte-plaquette qui est constitué de plusieurs parties devant être aboutées pour prendre en sandwich la plaquette.

Dans l'invention, le support n'a pas à être nécessairement démonté car du fait qu'il forme un cadre et que l'étanchéité est faite au niveau de la tranche de la plaquette (le substrat), la plaquette est associée en se logeant directement dans ce cadre.

Dans le cas d'une pluralité d'ouvertures pour traiter concomitamment plusieurs substrats, chaque ouverture forme un cadre de la même manière que ci-dessus pour accueillir un substrat.

De manière préférée, chaque moyen de calage d'un substrat au niveau d'une ouverture est réglable par rapport au plan de l'ouverture, c'est-à-dire dans une direction perpendiculaire par rapport au plan de l'ouverture, et/ou réglable parallèlement au plan de l'ouverture (donc par rapport à la distance du substrat), en fonction des dimensions du substrat, le substrat étant destiné à être parfaitement parallèle au plan de l'ouverture qui l'accueille ou à être incliné par rapport à l'ouverture et au joint d'applique.

Autour d'une ouverture, plusieurs moyens de calage, du type picots associés au support, sont disposés. Chaque picot de calage est apte à être réglé distinctement. Lorsqu'ils sont tous réglés à la même profondeur, le substrat est destiné à être agencé de manière parallèle au plan de l'ouverture. Lorsque les picots sont réglés à différentes profondeurs, le substrat est incliné par rapport au plan de l'ouverture.

L'inclinaison du substrat dans la présente invention n'est pas réalisée par rapport au bâti mais avantageusement par rapport au joint d'applique.

Dans la présente invention, l'inclinaison du substrat par rapport au joint d'applique est de l'ordre du degré, ce qui permet de faire varier le taux de recouvrement de la surface du chant du substrat par le joint d'applique entre une valeur minimale et une valeur maximale. Il est ainsi possible de traiter en une seule opération différemment la tranche du substrat, en minimisant l'étendue de la surface du chant traitée en un point de la périphérie du substrat et en la maximisant du côté diamétralement opposé, tout en assurant une étanchéité parfaite.

A titre d'exemple, l'inclinaison d'une plaquette de un ou deux degrés, voire moins, permettra de découvrir et donc de traiter une fraction plus importante de la surface de la tranche de la plaquette au niveau local où le joint ne recouvre pas cette partie du chant de la plaquette. A l'inverse, la partie du chant en son point diamétralement opposé sera davantage recouverte par le joint. Par exemple, après une porosification de la surface d'une plaquette de silicium, en couche épaisse sur une dizaine à quelques dizaines de micromètres de profondeur par un procédé électrochimique, l'inclinaison de la plaquette jouera un rôle essentiel dans le bon déroulement du détachement de la couche poreuse en favorisant notamment l'initiation du détachement du côté où la porosification du chant aura été la plus importante. L'intérêt étant de réduire les risques de détachement intempestif de la couche poreuse sur le reste de la périphérie de la plaquette avant l'initiation du détachement proprement dite.

On entend dans la suite de la description par « position de repos » relative au joint d'applique, la position pour laquelle aucune force de compression n'est exercée contre le substrat, et par « position de serrage », la position dans laquelle le joint d'applique via l'élément déformable exerce une force de compression de sorte à maintenir fermement le substrat dans son support et d'assurer l'étanchéité entre les deux faces opposées du substrat.

On parlera de « travail en mode pressurisation » lorsque le serrage des substrats sera assuré pendant l'application d'une pression dans l'élément gonflable. On parlera de « travail en mode dépressurisation » lorsque le serrage des substrats sera assuré par relâchement du vide appliqué dans la chambre de l'élément gonflable. Le mode pressurisation est le plus utilisé. L'intérêt du travail en mode dépressurisation est de garantir le maintien des substrats en cas de fuite dans le circuit de dépressurisation.

En position de serrage du joint d'applique, ce dernier autour du substrat maintient ainsi en position étanche ledit substrat vis-à-vis des deux milieux électrolytiques avec lesquels les deux faces respectives opposées du substrat seront destinées à être en contact.

Chaque joint d'applique est donc destiné à coopérer par cerclage autour de son substrat et assurer des forces de serrage contre son chant.

Chaque joint d'applique est apte à se déformer pour assurer une coopération avec son substrat par compression.

Chaque joint d'applique présente un profil et une dureté tels qu'il est destiné à assurer un contact étanche sur tout le contour de la tranche du substrat, en position de serrage.

Le profil et la dureté du joint d'applique sont particulièrement adaptés pour que le recouvrement corresponde à de préférence environ 90 à 100% de l'épaisseur de la plaquette lorsque la plaquette est insérée sans inclinaison. Pour rappel, une plaquette de silicium possède une épaisseur comprise généralement entre 200 µm et 1 mm, voire plus, avec des diamètres compris entre 50 mm (2 pouces) et 450 mm (18 pouces).

Le profil (le périmètre et la forme) du joint d'applique est adapté à la périphérie du substrat, à savoir à la longueur et à la forme géométrique du périmètre du substrat à porter.

En particulier, au-delà de la forme générale du substrat, le joint d'applique peut présenter sur le pourtour de son chant destiné à être en applique contre le substrat des aspérités ou des concavités parfaitement définies pour combler un relief particulier dans l'épaisseur du chant du substrat. Ce sera par exemple le cas pour le traitement d'une plaquette de silicium de diamètre supérieur ou égal à 200 mm, qui possède le plus souvent une encoche (appelée notch) servant de moyen de repérage pour positionner idéalement ladite plaquette dans son utilisation ultérieure. Le joint d'applique présentera un ergot de forme complémentaire à l'encoche de manière à pouvoir s'y s'introduire aisément de manière intime et à pouvoir s'en retirer tout aussi rapidement et facilement.

Le (ou chaque) joint d'applique peut d'autre part présenter des évidements borgnes sur ses faces latérales transversalement au chant d'applique du joint. Ces évidements sont borgnes et donc nullement traversants selon l'épaisseur du joint pour conserver une membrane de séparation flexible et ainsi préserver l'étanchéité entre les deux faces opposées du substrat lorsque celui-ci est en place.

Les évidements sont destinés à canaliser les forces compressives dans les régions conservées plus épaisses du joint et à accroître ainsi localement l'amplitude de la course de déplacement du chant interne du joint d'applique en direction du substrat.

Le joint d'applique destiné à s'appliquer directement contre le substrat présente un corps unitaire au périmètre fermé. Ainsi l'étanchéité de la face à traiter par rapport au liquide en contact avec l'autre face est garantie de manière sûre tout autour du substrat.

Le joint d'applique possède un profil et une dureté adaptés à épouser la tranche du substrat. Lorsque le substrat est mis en position dans l'ouverture du joint d'applique, le joint d'applique affleure le substrat lorsque ledit substrat repose sur des picots de calage, ou supporte légèrement le substrat lorsque le moyen de calage prend la forme d'un décrochement dans ledit joint d'applique pour former une butée. Cette mise en position du substrat avec le joint d'applique n'est pas encore en contact intime et en compression de sorte à assurer l'étanchéité.

Selon la variante adoptée, la pression pneumatique ou la dépressurisation appliquée dans l'élément gonflable peut être contrôlée de manière dynamique de façon à ce que le joint d'applique, combiné à son profil, exerce sur la tranche du substrat une compression appropriée pour garantir l'étanchéité sans trop comprimer le substrat au risque sinon de l'abîmer.

Dans le cas d'un travail en mode dépressurisation, le vide appliqué dans la chambre de l'élément gonflable pourra être maintenu partiellement de manière à contrôler l'expansion de la chambre de l'élément gonflable et à éviter ainsi une compression trop importante du joint d'applique. Dans un mode préféré du travail en mode dépressurisation de l'élément gonflable, la position de serrage sera atteinte en relâchant le vide jusqu'à la pression atmosphérique.

La pression ou la dépressurisation exercée par le système pneumatique peut donc être contrôlée et réajustée en cas de dérive des conditions de traitement électrolytique, dues par exemple, à une déformation du substrat ou bien encore à une augmentation du courant de fuite résiduel au niveau de l'interface joint/substrat. Ainsi, en cas de détection de déformation du substrat au cours du traitement, on veillera à relâcher la contrainte exercée par l'élément déformable gonflable et donc à relâcher la pression exercée par le joint d'applique. En cas de courant de fuite détecté, on pourra tenter en premier lieu d'agir sur la compression du joint d'applique pour augmenter encore le contact intime de serrage du joint sur le substrat.

Par conséquent, de manière avantageuse, le dispositif donne l'opportunité de contrôler la qualité de l'étanchéité et de limiter la déformation éventuelle des plaquettes en agissant sur la pression appliquée à l'intérieur de la chambre de l'élément gonflable au cours du traitement.

L'invention qui utilise d'une part un joint d'applique (ou plusieurs lorsque plusieurs substrats sont à traiter concomitamment) et d'autre part au moins un élément déformable gonflable pour transmettre des forces de compression au joint d'applique, présente notamment les avantages suivants, outre le fait de maîtriser plus facilement l'homogénéité du serrage sur tout le pourtour du substrat sans risque de l'abîmer :
- le joint d'applique, qui s'use plus vite en contact avec la solution d'électrolyte et le substrat, peut être aisément remplacé ;
- l'élément déformable gonflable n'a pas à présenter les particularités de forme et de dureté du ou des joints d'applique en contact avec les substrats ;
- le support et l'élément déformable gonflable peuvent être réutilisés, indépendamment des joints d'applique adaptés à chaque forme et taille de substrats ;
- un joint d'applique plein sera plus facile et moins cher à fabriquer qu'un élément gonflable de type joint gonflable à chambre fermée fabriqué par extrusion puis soudage ;
- il est aisé de s'adapter à tous types de profil périphérique et de diamètre du substrat indépendamment de l'élément déformable gonflable et du support. Seul est à prévoir un profil et un périmètre intérieur adaptés pour le joint d'applique en contact avec le substrat, ce joint étant facilement insérable dans son logement d'accueil et facilement interchangeable en fonction du profil du substrat.
- la présence d'un élément déformable gonflable permet de travailler aussi bien par mise en surpression de la chambre de l'élément gonflable initialement dégonflé que par remontée à la pression atmosphérique dans la chambre de l'élément gonflable préalablement dépressurisé, sans risque d'infiltration de produits liquides ou gazeux extérieurs.

Le dispositif de l'invention peut d'autre part comprendre au moins un cadre de guidage et d'adaptation (à raison d'un par ouverture) pour s'opposer aux déformations transversales d'un joint d'applique devenu trop large pour guider sans fléchir les forces de compression en direction d'un substrat de trop petite taille. Chaque cadre de guidage permet, en gardant le même support et le ou les mêmes éléments déformables gonflables, de s'adapter à différentes familles de substrats avec des tailles et/ou formes spécifiques. A ce titre, ces cadres de guidage servent également d'adaptateurs aux dimensions des substrats.

Chaque cadre de guidage est coplanaire avec l'ouverture et coopère avec celle-ci en prolongeant le logement d'accueil du joint d'applique destinée à coopérer avec un substrat (et rétrécissant la dimension de l'ouverture), ledit logement d'accueil étant toujours en regard de la cavité du support logeant l'élément déformable gonflable.

Par conséquent, selon une caractéristique, le dispositif comporte au moins un cadre de guidage formé de préférence par l'association de deux demi-cadres et coopérant avec une ouverture, ledit cadre de guidage comprenant un logement d'accueil pour loger la partie du joint d'applique destinée à coopérer avec un substrat, ledit logement d'accueil étant en regard du logement d'accueil du support logeant l'autre partie du joint d'applique destinée à être en contact avec l'élément gonflable, de préférence ledit cadre de guidage comprenant des moyens de calage du substrat.

Le dispositif de support présente également l'intérêt de pouvoir s'adapter à tout type de forme et de dimension de substrat en lui associant différents couples de joint d'applique et de cadre de guidage.

L'élément déformable gonflable et le joint d'applique sont amovibles par rapport au support de manière à pouvoir les changer, par exemple lorsqu'ils sont usés, et à pouvoir adapter la taille et la forme du joint d'applique à chaque profil de substrat à traiter.

Le logement accueillant le joint d'applique accueille en outre l'élément gonflable, ledit logement comportant des parois constituant des butées vis-à-vis de la dilatation de l'élément gonflable, lesdites butées étant destinées à limiter la compression exercée sur le joint d'applique positionné en regard.

Le support comporte au moins une cavité dans laquelle est logé au moins un élément déformable gonflable, et au moins une gorge débouchant d'un côté sur ladite cavité et du côté opposé sur au moins une ouverture destinée à accueillir un substrat, la gorge formant le logement d'accueil d'un joint d'applique.

En mode pressurisation, l'élément gonflable à l'état de repos n'occupe qu'une partie de la cavité, ménageant ainsi un espace permettant au joint d'applique de prendre en partie place dans ledit espace de la cavité. L'espace permet en outre à l'élément gonflable lorsqu'il est gonflé de répartir les forces de compression contre le chant extérieur du joint d'applique à comprimer, et les parois de la cavité servent en quelque sorte de butées de dilatation de l'élément gonflable favorisant ainsi son expansion en direction du joint d'applique comme dit plus haut.

A l'inverse, en mode dépressurisation, l'élément gonflable à l'état de repos tendra à remplir la totalité de la cavité et à exercer des forces compressives sur le joint d'applique.

Le volume de la cavité dans lequel l'élément déformable gonflable se dilate lors d'une pressurisation pourra différer localement sur le contour du cadre afin d'adapter le volume d'expansion dudit élément et engendrer une course de déplacement du joint d'applique vers le substrat qui différera localement. Ceci est une autre manière de s'adapter aux spécificités de la périphérie des substrats, comme par exemple au(x) méplat(s) d'une plaquette de silicium. Chaque joint d'applique en contact avec son substrat épouse ainsi parfaitement le profil du substrat.

En particulier, le logement accueillant l'élément gonflable présente localement un volume plus large du côté du joint d'applique que du côté opposé de sorte que cela engendre une dilatation plus importante de l'élément gonflable en direction dudit joint d'applique et donc un déplacement du joint d'applique plus important en direction du substrat.

L'expansion de l'élément déformable gonflable comprime les joints d'applique en direction des substrats. Les parois des gorges menant aux cavités servent de logement d'accueil et de guidage des joints d'applique qui ne risquent pas de fléchir ou de se plier lorsqu'ils rentrent en contact avec les substrats. Chaque joint d'applique enserre alors fermement son substrat associé avec des forces parallèles au plan du substrat ou quasi parallèles en cas d'inclinaison du substrat.

Pour chaque ouverture, des moyens de guidage peuvent être rapportés extérieurement sur le support, afin de prolonger les parois de la gorge et contenir un joint d'applique plus large, afin de serrer un substrat de plus petite dimension. Il n'y a ainsi pas besoin de modifier le support au regard de l'élément déformable gonflable interne au support.

Le cadre de guidage rapporté consiste par exemple au regard d'une ouverture, en un cadre amovible, que l'on associe autour d'une ouverture de manière à en réduire sa taille et à prolonger les parois de la gorge accueillant le joint d'applique et débouchant sur l'ouverture. Chaque cadre de guidage s'appuie sur le support, et lui est associé en étant maintenu par vissage ou par tout autre moyen de fixation amovible.

Chaque cadre de guidage sera normalement adapté pour satisfaire l'utilisation de familles de joints d'applique de tailles légèrement différentes de façon à ce que le joint d'applique ne fléchisse pas lors de sa compression et de son serrage contre la tranche du substrat.

Ainsi, de façon générale, les logements comprenant gorges et cavités pour accueillir les éléments déformables gonflables et les joints d'applique comportent des parois servant de butées ainsi que des parois de guidage de la déformation par compression des joints d'applique.

L'invention a également trait à un ensemble comprenant le dispositif de support de l'invention précité et un système de mise sous pression/dépressurisation pneumatique qui est associé à ou aux éléments déformables gonflables, en particulier l'ensemble comprenant des moyens de contrôle de la mise en pression ou de dépressurisation pneumatique, des défaillances d'étanchéité et/ou de déformations de substrats détectées pendant le traitement.

L'élément déformable gonflable comprend au moins une chambre qui est apte à recevoir un fluide / se vider d'un fluide issu du système de mise sous pression/dépressurisation, engendrant la déformation de la chambre.

Lors de son utilisation, le dispositif de l'invention peut être indifféremment disposé verticalement ou horizontalement et s'adapter ainsi au type de bâti.

Selon l'invention, le dispositif de support est en particulier utilisé pour supporter un ou plusieurs substrats, du type plaquettes de silicium, à traiter, en particulier à structurer par voie électrochimique sur au moins l'une de leurs deux faces planes. A titre d'exemples nullement limitatifs, on peut citer des plaquettes monocristallines ou multi-cristallines, ou encore des plaquettes mixtes du type isolant/semi-conducteur, et aux formes et dimensions variées, telles que circulaires de 2 à 12 pouces de diamètre et plus, de formes carrées ou rectangulaires, avec ou sans coins arrondis.

La présente invention est maintenant décrite à l'aide d'exemples uniquement illustratifs et nullement limitatifs de la portée de l'invention, et à partir des illustrations ci-jointes, dans lesquelles :
- La figure 1 représente une vue en perspective du dispositif de support de l'invention selon l'une de ses faces, dépourvu du joint d'étanchéité d'applique;
- La figure 2 est une vue de la figure 1, le dispositif portant un substrat en vue d'être traité;
- La figure 3 illustre une vue en perspective avec coupe médiane d'une moitié du dispositif de la figure 1 ;
- La figure 4 est une vue schématique en perspective et en coupe du dispositif de l'invention portant un substrat et agencé en association avec un bâti de sorte à séparer deux milieux électrolytiques ;
- La figure 5 est une vue en coupe et schématique d'un mode de réalisation du logement du support accueillant les moyens d'étanchéité avant leur mise en pression ;
- La figure 6 correspond à la figure 5 selon une mise en compression des moyens d'étanchéité, en mode pressurisation;
- La figure 7 illustre en vue de détail le maintien d'une plaquette inclinée en position de serrage par le joint d'applique ;
- La figure 8 illustre une vue schématique partielle en coupe d'une variante d'un joint d'applique du dispositif de l'invention faisant apparaître un décrochement destiné à servir de moyen de calage / de butée à la plaquette avant serrage du substrat;
- La figure 9 illustre une vue schématique partielle en coupe d'une autre variante du joint d'applique avec des évidements dans son épaisseur pour canaliser les contraintes de déformation ;
- La figure 10a est une vue en perspective d'une variante de réalisation du dispositif de l'invention permettant de traiter plusieurs substrats ;
- La figure 10b est une vue éclatée de la figure 10a ;
- La figure 10c est une vue partielle en perspective de détail de la figure 10a ;
- La figure 11 est un autre exemple de réalisation d'un cadre délimitant l'ouverture d'accueil d'un substrat ;
- La figure 12 est une vue schématique en coupe d'une variante de la figure 10a au regard de l'élément déformable gonflable.

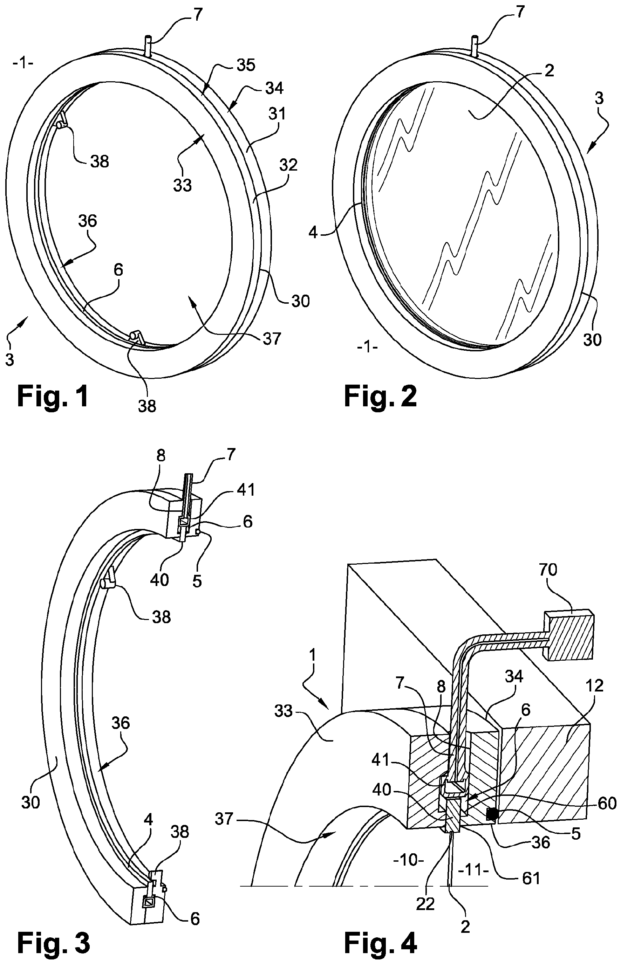

Le dispositif de support 1 illustré sur les figures 1 à 6 est destiné à supporter un substrat 2, telle qu'une plaquette de silicium, à traiter électro-chimiquement, en particulier par voie électrolytique.

Le substrat 2 est plan.

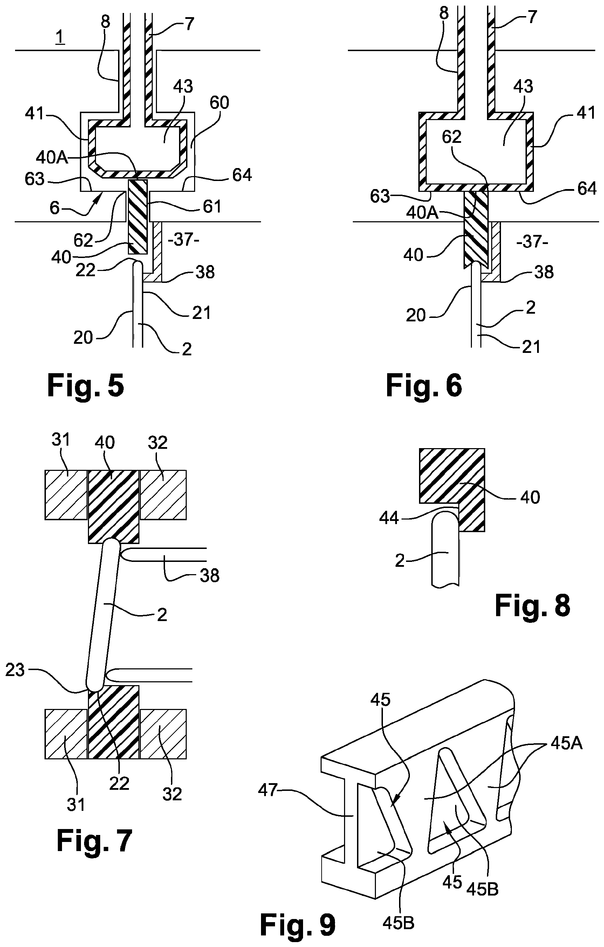

En regard des figures 5 et 6, le substrat présente deux faces principales 20 et 21 parallèles et opposées et un chant périphérique 22 reliant les deux faces. Le chant peut être droit ou courbe avec une convexité tournée vers l'extérieur dans la direction opposée au centre du substrat.

Le dispositif de support 1 comporte un support 3 qui est destiné, lorsque le substrat 2 lui est associé, à constituer une barrière étanche entre deux bains électrolytiques 10 et 11 de façon à isoler hermétiquement les faces opposées 20 et 21 du substrat, le bain en contact avec l'une des faces du substrat ne devant pas être en contact avec la face opposée du substrat en contact avec l'autre bain. A cet effet, le dispositif de support comporte des moyens d'étanchéité 4 qui sont associés au support 3 et sont destinés à coopérer avec le substrat 2.

Le support 3 comprend des moyens d'étanchéité supplémentaires 5 agencés sur au moins un côté externe dudit support qui est destiné à s'appuyer contre le bâti 12. Un logement périphérique est de préférence prévu dans la face externe 34 du cadre 30 pour y insérer les moyens d'étanchéité supplémentaires 5. Le support 3 est plaqué contre le bâti 12 avec les moyens d'étanchéité supplémentaires 5 en interface, et cela par tous moyens de pression appropriés s'exerçant sur ledit support 3 selon une force perpendiculaire au plan du substrat 2. Cet agencement des moyens d'étanchéité supplémentaires 5 est un exemple nullement limitatif. Ils pourront en variante être disposés sur le chant externe du support 3 qui sera prévu pour porter un ou plusieurs substrats.

En regard des figures, en particulier 1, 2 et 3, le support 3 présente selon l'invention un corps principal en forme de cadre 30, ici de forme circulaire mais qui pourrait être de géométrie différente telle que rectangulaire, carrée, ou autre. Le support 3 comporte les moyens d'étanchéité 4 formés d'un joint d'applique 40, et un élément déformable gonflable 41 associé au joint d'applique et destiné à transmettre des forces de compression au joint d'applique pour son serrage contre le substrat 2 lorsque celui-ci est logé dans le cadre 30.

Le cadre 30 peut être monobloc ou de préférence, tel qu'illustré, formé de deux demi-cadres 31 et 32 fixée l'un à l'autre de manière amovible, ce qui permet d'agencer plus aisément les moyens d'étanchéité 4 dans ce cadre et de les changer ultérieurement si besoin. Le plan de joint des deux demi-cadres est situé dans un plan médian au cadre parallèle aux surfaces générales du substrat à porter. Lorsque deux demi-cadres sont associés, ceux-ci sont par exemple assemblés par clipsage ou serrage par vis. Les moyens de fermeture/d'assemblage sont adaptés pour résister aux forces de pression exercées par l'élément gonflable 41 sur les parois internes des demi-cadres lors du serrage de la plaquette. Ces deux demi-cadres ont juste pour but de pouvoir accéder à l'élément gonflable, mais n'apportent rien au regard de l'association du substrat.

Le cadre 30 comprend deux faces externes opposées et parallèles 33 et 34, un chant externe 35, et un chant ou paroi interne 36. Le cadre 30, en particulier sa paroi interne 36, délimite une ouverture 37 qui est destinée à accueillir le substrat 2. L'ouverture 37 s'étend dans un plan général parallèle aux deux faces 33 et 34 du cadre, en particulier dans le plan médian réunissant les deux demi-cadres.

Le substrat 2 est logé dans cette ouverture 37 de sorte que ses deux faces opposées 20 et 21 sont parallèles ou sensiblement parallèle au plan général de l'ouverture. Dans un exemple d'application qui sera vu ultérieurement en regard de la figure 7, le substrat peut être monté légèrement incliné par rapport au plan de l'ouverture 37.

Selon l'invention (en référence aux figures 3 à 6), l'étanchéité entre les deux faces opposées 20 et 21 du substrat 2 est réalisée par le joint d'applique 40 qui coopère avec le chant 22 dudit substrat.

Le joint d'applique 40 est associé à la paroi interne (chant interne) 36 du cadre 30. Il est plus particulièrement accueilli dans un logement 6 ménagé dans ladite paroi 36.

Le logement 6 est adapté à la taille et à la forme du joint d'applique 40 et de l'élément gonflable 41 apte à coopérer avec le joint d'applique 40. Le logement 6 comporte une rainure ou gorge qui s'étend sur l'entière périphérie du chant interne 36 du cadre.

Dans le mode de réalisation illustré, le logement 6 comporte, en regard des figures 4 à 6, une cavité 60 ménagée dans l'épaisseur du cadre et une gorge radiale 61. La gorge 61 prolonge la cavité 60 de façon plus étroite et selon le plan général de l'ouverture, pour déboucher sur ladite ouverture 37.

Le joint d'applique 40 encercle l'ouverture 37. Il forme, au moins pour sa partie destinée à être en contact avec la tranche 22 du substrat, une ligne continue fermée.

L'élément gonflable 41 se présente sous la forme d'un tuyau déformable fermé de type joint creux doté d'une chambre interne 43, et muni d'un raccord flexible 7 ou bien sous la forme d'un tuyau déformable ouvert, avec des propriétés élastiques et de préférence de tenue à l'agressivité des électrolytes analogues à celles du joint d'applique. L'élément gonflable 41 présente au moins une partie déformable sous l'application d'une force par mise en pression ou dépressurisation de la chambre 43.

Avant la mise en pression ou après la mise en dépressurisation de l'élément gonflable 41, le substrat 2 est disposé au niveau de l'ouverture du cadre 30 tel qu'un jeu existe entre la tranche 22 du substrat et le joint d'applique 40 destiné à s'appliquer contre ladite tranche.

Le joint d'applique 40 peut être plein (figures 5 et 6), être refermé sur lui-même en étant creux (cavité interne fermée), ou encore plein et doté d'évidements (figure 9). Il présente au moins une partie qui est de surface pleine pour s'appliquer en continue contre le substrat.

Le joint d'applique 40 présente une section fermée pour former une ligne fermée périphérique correspondant à la forme géométrique externe du substrat.

L'élément gonflable 41 est apte à se dilater, se déformer pour comprimer le joint d'applique 40.

On distingue deux variantes de mise en oeuvre afin que l'élément déformable gonflable 41 puisse exercer des forces de compression sur le joint d'applique 40, à savoir un mode dit de pressurisation et un mode de dépressurisation.

En mode pressurisation, lorsqu'aucune pression pneumatique n'est appliquée à l'élément gonflable 41, celui-ci n'est pas expansé, et le joint d'applique 40 au plus proche du substrat présente une section intérieure (un diamètre pour une forme annulaire) plus grande que la section (le diamètre) du substrat, permettant de positionner sans effort le substrat dans l'ouverture 37 du cadre 30. Lorsque ledit élément 41 est gonflé, celui-ci comprime le chant externe du joint d'applique 40 pour transmettre une compression à son côté opposé de façon à se plaquer par pression contre la tranche 22 du substrat et l'épouser. Le joint d'applique 40 enserre alors parfaitement le substrat et serre sa tranche 22, tel qu'illustré sur la figure 6.

En mode dit de dépressurisation, l'élément gonflable 41 est initialement gonflé et expansé, et s'appuie sur le joint d'applique alors même qu'il n'y a pas de substrat. Pour insérer le substrat 22 dans l'ouverture 37, cela n'est possible qu'en dépressurisant la chambre 43 de l'élément gonflable 41. En se contractant, ledit élément 41 relâche la compression qu'il exerce sur le joint d'applique 40, qui à son tour se rétracte. Le joint d'applique 40 se rétracte alors suffisamment pour que son périmètre intérieur redevienne plus grand que le celui du substrat de manière à mettre en place le substrat. Le retour vers la pression atmosphérique dans la chambre 43 entraîne à nouveau l'expansion de l'élément gonflable 41 engendrant à son tour la compression du joint d'applique 40 et le serrage du substrat.

Cette réalisation selon l'invention permet de maîtriser plus facilement l'homogénéité du serrage sur tout le pourtour du substrat sans risque de l'abîmer, notamment au regard de la grandeur des forces de compression et de la répartition de ces forces.

A noter que le cadre 30 est formé de deux demi-cadres 31 et 32. Il n'est pas nécessaire d'ouvrir le cadre, c'est-à-dire de dissocier les deux demi-cadres, pour associer le joint d'applique 40 au cadre, le joint peut être directement introduit dans la gorge 61.

Le chant interne du joint d'applique 40 destiné à être en compression contre le substrat ainsi que les forces de compression, sont adaptés pour recouvrir intégralement le profil de la tranche 22 du substrat (figure 6), ou partiellement tel qu'en référence 23 de la figure 7 montrant un agencement du substrat incliné.

Le positionnement du substrat dans le plan général de l'ouverture en vis-à-vis du joint d'applique 40 est facilité grâce aux butées 38 (figures 1, 3 et 5, 6 et 7) solidaires du support 3, en particulier du demi-cadre 32.

En variante, les butées pour positionner le substrat correctement dans le plan de l'ouverture pourraient correspondre à des portions spécifiques du joint d'applique. Tel que visible sur la figure 8, le joint d'applique 40 est profilé en comprenant un décrochement 44 formant d'une part un volume coplanaire à l'ouverture d'accueil du substrat et d'autre part une butée contre laquelle s'appuie le substrat 2 pour son positionnement à plat afin de retenir le substrat dans le plan de l'ouverture avant l'opération de serrage.

En regard des figures 5 et 6, l'élément déformable gonflable 41 est de type joint et comporte une chambre intérieure 43 annulaire s'étendant sur tout le périmètre dudit élément déformable. En mode pressurisation, un fluide sous pression (préférentiellement de l'air) est destiné à être injecté dans cette chambre 43, via le raccord flexible d'alimentation en gaz 7, de sorte à dilater les parois de l'élément gonflable 41. Les valeurs de pression pneumatique appliquées dépendent de la dureté des matériaux utilisés pour la fabrication de l'élément déformable. La pression est par exemple de quelques bars. En mode dépressurisation l'expansion de l'élément gonflable intervient lors de sa remise en pression atmosphérique. Le taux de compression exercé par l'élément gonflable dépend alors de la dureté du matériau utilisé et de l'amplitude de la précontrainte initialement appliquée à l'élément gonflable pour l'introduire dans la cavité 60.

Le dispositif de l'invention comporte (figures 1 à 6) au moins un raccord 7 d'alimentation en gaz coopérant avec l'élément déformable 41, et traversant le cadre 30 via une conduite 8. Le raccord 7 est connecté, depuis une terminaison, à la chambre 43 du joint, et au niveau de sa terminaison opposée, est destinée à être reliée à un système pneumatique 70.

Le logement 6 du cadre accueillant l'élément déformable gonflable 41, en particulier la cavité 60 logeant l'élément déformable gonflable 41, présente un espace délimité par des parois, qui est adapté à l'augmentation de volume de l'élément gonflable et à la direction principale de déformation à imposer au joint d'applique 40, c'est-à-dire radialement en direction de l'ouverture 37 pour exercer des forces de poussée principalement contre ledit joint d'applique 40 en direction du substrat.

De plus, tout le périmètre de la cavité 60 (figures 5 et 6) du cadre 30 communique avantageusement avec la gorge radiale 61 au niveau d'un rétrécissement 62 ménagé par les parois 63 et 64 transversales aux faces 33 et 34 du cadre 30 du support 3 et coplanaires ou sensiblement coplanaires avec le chant externe 40A du joint d'applique 40 contre laquelle l'élément déformable gonflable 41 vient se plaquer. Ces parois transversales 63 et 64 constituent des butées pour la dilatation de l'élément déformable gonflable, permettant ainsi de fixer efficacement une limite de contrainte maximale applicable sur le joint d'applique. Ainsi, si la compression induite par l'élément gonflable 41 devient trop importante, ces butées 63 et 64 assurent que le joint d'applique 40, et donc le substrat, subissent une contrainte constante.

Tant que l'élément gonflable 41 ne vient pas comprimer le joint d'applique 40, ledit joint ne vient pas enserrer le substrat 2. Le substrat 2 est alors provisoirement maintenu au niveau de l'ouverture 37 grâce aux moyens de calage 38 (figures 1 à 4) prévus sur la périphérie intérieure du cadre ou bien encore en reposant sur le décrochement 44 du joint d'applique 40 par un profil adapté (figure 8). Tant que l'élément gonflable 41 ne vient pas comprimer le joint d'applique 40, l'herméticité entre les deux bains 10 et 11 n'est pas assurée, ni entre le substrat 2 et le joint d'applique 40, ni entre le joint d'applique 40 et l'élément gonflable 41 et ni entre l'élément gonflable 41 et le cadre 30.

Lorsque le joint d'applique est en position de serrage, l'herméticité entre les deux bains est assurée à tous les niveaux entre le cadre 30 et l'élément gonflable 41, l'élément gonflable 41 et le joint d'applique 40 et le joint d'applique 40 et le substrat 2.

La figure 9 illustre une vue partielle d'une variante de joint d'applique 40 doté dans son épaisseur d'évidements borgnes (non traversants) 45 (les évidements étant creusés dans la direction perpendiculaire à son extension longitudinale). Le joint reste plein au niveau de ses chants externes opposés destinés à être en contact avec le substrat et l'élément gonflable 41. La forme, la profondeur et la localisation judicieuses de ces évidements sont destinées à favoriser le déplacement du joint d'applique en direction du substrat. La diminution du volume de matière déformable du joint permet de réduire la quantité d'énergie à emmagasiner pour atteindre une amplitude de déplacement donnée. A énergie constante le joint d'applique pourvu de ces évidements augmentera sa course en direction du substrat.

Les parties pleines 45A entre deux évidements 45 ont de préférence une forme triangulaire dont un sommet du triangle est placé du côté de la partie destinée à être appliquée contre le substrat tandis que la base opposée du triangle est sensiblement parallèle au chant externe du joint, de façon à canaliser et conduire les forces dans la matière entre les évidements et déformer le joint avec une amplitude de mouvement accrue radialement contre le substrat, concentrant les forces de compression vers la pointe des triangles.

Le fond 45B des évidements 45 forme une membrane étanche assurant l'herméticité entre les bains 10 et 11 pendant le serrage du substrat.

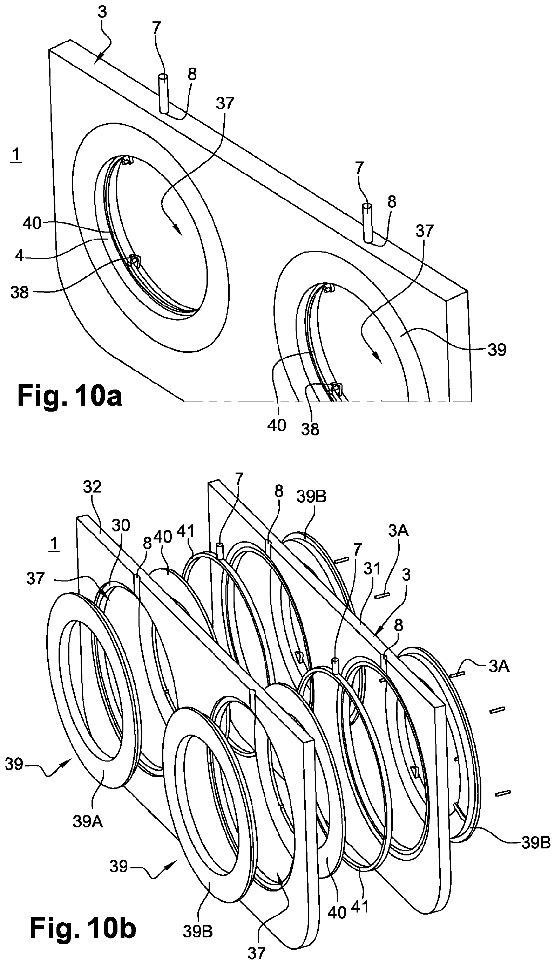

La figure 10a illustre un dispositif 1 de l'invention comportant plusieurs ouvertures 37, ici deux, chacune d'entre elles étant pourvue d'un élément déformable gonflable 41 distinct, pour loger et traiter plusieurs substrats concomitamment.

Chaque ouverture 37, telle que vue précédemment, est délimitée par un cadre doté d'une gorge accueillant un joint d'applique 40. Des moyens de calage 38 sont prévus pour maintenir en position avant serrage le substrat à traiter.

La figure 10b montre une vue éclatée de la figure 8. On retrouve le support 3 formée de deux demi-cadres assemblés 31 et 32 délimitant deux cadres 30 pour deux ouvertures 37, ainsi qu'un joint d'applique 40 et un élément gonflable 41 par ouverture.

En outre, dans cet exemple de réalisation, le dispositif de l'invention présente l'avantage de s'adapter aisément à tous types de formes et dimensions d'un substrat en associant d'une part à chaque ouverture 37, un cadre supplémentaire 39 dit de guidage associé au support 3, et d'autre part un joint d'applique 40 plus large adapté à la forme du cadre de guidage et à la forme du substrat. La fonction du cadre de guidage 39 est de réduire la dimension/la forme de l'ouverture 37 afin de l'adapter à la dimension/la forme du substrat 2 sans avoir à modifier ni le support 3 ni l'élément gonflable 41. Une autre fonction du cadre 39 est de guider le mouvement radial du joint d'applique 40 sans déformation latérale dudit joint.

Le cadre de guidage 39 est par exemple formé de deux demi-cadres 39A et 39B associés de manière amovible par des moyens de fixation 3A au support 3 de part et d'autre de chaque ouverture 37.

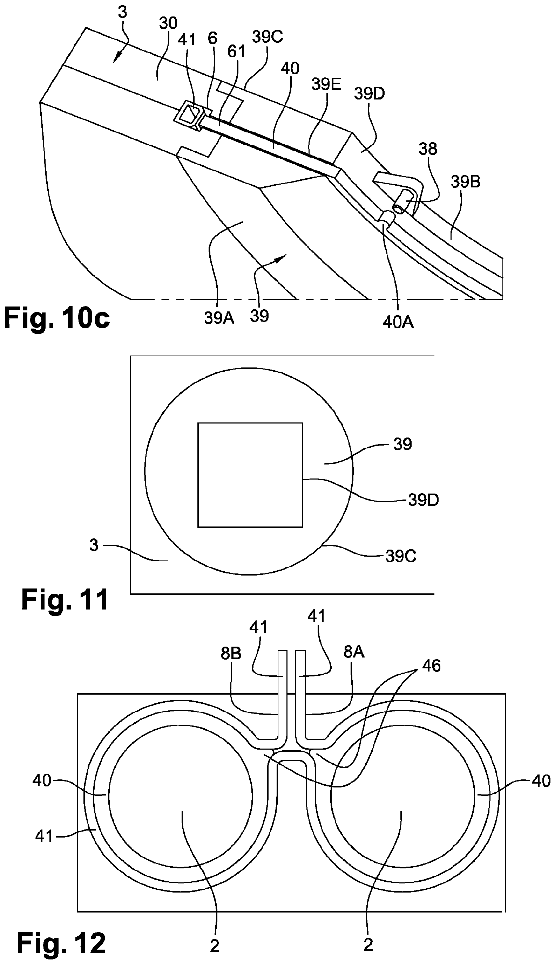

Au regard de la figure 10c, le cadre d'adaptation 39 est rapporté contre le cadre 30 initial du support 3 qui comprend l'élément gonflable 41. Le cadre d'adaptation 39 présente d'une part une forme externe 39C adaptée pour coopérer avec le support 3, et d'autre part une forme interne 39D de forme adaptée à la géométrie du substrat à accueillir. Sur les figures 9 à 11, cette forme interne 39D est circulaire. Toujours sur la figure 10c, le demi-cadre 39A, opposé à celui portant les éléments de calage 38, est biseauté de manière à faciliter la circulation de l'électrolyte et l'évacuation des dégagements gazeux qui peuvent se produire à la surface du substrat.

Dans la variante illustrée schématiquement sur la figure 11, le cadre d'adaptation 39 présente une forme circulaire externe 39C pour coopérer avec le cadre 30 et une forme interne 39D rectangulaire pour coopérer avec une forme correspondante rectangulaire de substrat.

En regard de la figure 10c, le cadre d'adaptation 39, composé des deux demi-cadres 39A et 39B, forme un logement d'accueil 39E pour le joint d'applique 40. Le logement d'accueil 39E est situé dans le prolongement de la gorge 61 du support 3 ; ses parois servent à maintenir et guider le joint d'applique 40 afin que, lors de l'expansion de l'élément gonflable 41, les forces de compression transmises par le joint d'applique 40 soient dirigées en direction de l'ouverture 37.

Le joint d'applique 40 présente une forme et des dimensions adaptées pour, d'une part être logé dans la gorge 61 du support 3 et dans le logement 39E du cadre 39, et d'autre part coopérer avec le profil du pourtour du substrat.

Dans l'exemple illustré sur cette figure 10c, le joint d'applique 40 comporte un ergot 40A pour coopérer avec une forme femelle du type « notch » d'une plaquette de silicium.

Le dispositif 1 peut comporter dans sa structure interne un élément déformable 41 associé à chaque joint d'applique 40, tel qu'illustré sur la figure 10a.

En variante sur la figure 12, le dispositif comporte un unique élément déformable 41 de type tuyau flexible qui présente une longueur adaptée pour entourer chaque joint d'applique 40. L'élément gonflable 41 ne se présente plus comme un joint gonflable à section fermée, mais suit une ligne continue depuis une première conduite 8A, en serpentant autour de chaque joint d'applique, jusqu'à venir déboucher en sortie hors du support 3 via une seconde conduite 8B.

Dans cette variante de la figure 12, le chant externe de chaque joint d'applique 40 présente un profil adapté localement, ici en forme de bec 46, destiné à colmater l'espace formé au niveau de la jonction d'arrivée et de sortie du tuyau en un point de chaque ouverture du cadre destinée à loger un substrat 2. En cet endroit, l'élément gonflable 41 se resserre pour encercler chaque ouverture sans pouvoir jointer à angle droit. L'expansion de l'élément gonflable 41 (quel que soit le mode pressurisation/dépressurisation) entraîne la compression des joints d'applique et le pincement de chacun des becs 46, assurant alors l'étanchéité. La somme des forces de compression s'exerçant sur un bec 46 contribue à déformer le joint d'applique en direction du substrat 2, assurant ainsi une étanchéité parfaite entre le support 3 et l'élément gonflable 41, ainsi qu'entre l'élément gonflable 41 et les joints d'applique 40 et entre les joints d'applique 40 et les substrats 2.

Par conséquent, le dispositif de support de l'invention pour substrat à traiter par exemple par voie électrochimique permet, par la forme générale en cadre du corps du support, la présence de moyens d'étanchéité sur le pourtour intérieur du cadre, l'adaptation des moyens d'étanchéité à se dilater, en particulier sous l'effet d'une mise en pression pneumatique ou d'un relâchement de pression, de monter/démonter le substrat à ce support de manière rapide, répétée pour une application industrielle, et de fournir une étanchéité efficace entre les deux surfaces opposées du substrat tout en maximisant la surface à traiter du substrat.

D'une part le joint d'applique est ainsi déformable à son tour, ce qui permet une coopération maîtrisée avec le substrat selon le chant de ce dernier, de sorte à limiter la zone de recouvrement du joint à la tranche du substrat, maximisant ainsi la zone apte à être traitée.

De plus, le dispositif de l'invention, en particulier le support, est utilisable pour plusieurs formes de substrats, seul est à fabriquer un joint d'applique spécifique à chaque géométrie de substrat et éventuellement un cadre de guidage lorsque le joint d'applique devient trop large.

Ce dispositif de support accepte des jeux de cadres de guidage et de joints d'applique supplémentaires destinés à adapter le support à tout type de forme et dimension de substrat à traiter.

Enfin, le dispositif de l'invention peut traiter plusieurs substrats à la fois.

## Revendications

1. Dispositif de support (1) d'au moins un substrat à traiter électro-chimiquement, comprenant :
- un support doté d'au moins une ouverture traversante (37), l'ouverture étant destinée à accueillir un substrat (2) à traiter, et s'étendant dans un plan général qui est destiné à être parallèle au plan de la ou des surfaces à traiter,
- au moins un joint d'applique (40) accueilli dans un logement (6) du support, s'étendant selon un périmètre encerclant l'ouverture, et destiné à s'appliquer contre le substrat lorsque ce dernier est logé dans l'ouverture,
- des moyens déformables gonflables pour assurer au joint d'applique d'exercer des forces de compression de direction transversale au chant du cadre du support et dirigées vers l'ouverture, de sorte à appuyer le joint d'applique contre le chant du substrat,
**caractérisé en ce que** les moyens déformables gonflables sont distincts du joint d'applique et sont constitués d'au moins un élément déformable gonflable (41) disposé autour dudit joint d'applique (40), à l'opposé de l'ouverture.

2. Dispositif de support selon la revendication 1, **caractérisé en ce qu'**il comporte, de préférence dans le même support (3), plusieurs ouvertures (37) destinées chacune à accueillir un substrat à traiter, chaque ouverture étant dotée en périphérie d'un logement (6) comprenant un joint d'applique (40) pour coopérer avec un substrat, et **en ce qu'**il comprend au moins un élément déformable gonflable (41) apte à coopérer par compression tout autour de chaque joint d'applique (40), de préférence l'élément gonflable (41) étant logé également dans ledit support (3).

3. Dispositif de support selon l'une quelconque des revendications précédentes, **caractérisé en ce que** une ouverture (37) du support délimite un cadre (30) dont le chant (36) est doté d'une gorge (61) logeant un joint d'applique (40), le chant interne du joint d'applique destiné à être en regard du substrat présentant un profil correspondant à la forme géométrique du pourtour du substrat.

4. Dispositif de support selon la revendication 2 , **caractérisé en ce qu'**il comporte plusieurs ouvertures associées chacune à un joint d'applique, et **en ce que** le dispositif comporte plusieurs éléments gonflables, chacun associé à un joint d'applique, ou bien comporte un unique élément gonflable pour plusieurs joints d'applique, de forme et longueur adaptées pour courir d'un seul tenant autour de chaque joint d'applique.

5. Dispositif de support selon l'une quelconque des revendications précédentes, **caractérisé en ce que** le ou chaque joint d'applique (40) comporte des évidements borgnes (45) sur ses faces latérales transversalement au chant d'applique du joint.

6. Dispositif de support selon l'une quelconque des revendications précédentes, **caractérisé en ce que** l'élément gonflable (41) est un joint creux du type à section unitaire fermée et doté d'un orifice d'échappement, ou du type à ligne ouverte et comprenant deux extrémités libres, l'orifice d'échappement ou les extrémités libres étant aptes à être raccordés à des moyens de mise en pression ou de dépressurisation pneumatique.

7. Dispositif de support selon l'une quelconque des revendications précédentes, **caractérisé en ce que** le logement (6) accueille en outre l'élément gonflable (41), ledit logement comportant des parois (63, 64) constituant des butées vis-à-vis de la dilatation de l'élément gonflable (41), lesdites butées étant destinées à limiter la compression exercée sur le joint d'applique (40) positionné en regard.

8. Dispositif selon la revendication précédente, **caractérisé en ce que** le logement (6) accueillant l'élément gonflable (41) présente localement un volume plus large du côté du joint d'applique que du côté opposé de sorte que cela engendre une dilatation plus importante de l'élément gonflable en direction dudit joint d'applique et donc un déplacement du joint d'applique plus important en direction du substrat (22).

9. Dispositif de support selon l'une quelconque des revendications précédentes, **caractérisé en ce qu'**il comporte des moyens de calage (38, 44) destinés à assurer le maintien du substrat par application d'au moins une face du substrat contre lesdits moyens de calage, de préférence lesdits moyens de calage étant solidaires du support (3) ou du joint d'applique (40), les moyens de calage étant éventuellement réglables par rapport au plan de l'ouverture, le substrat étant destiné à être parfaitement parallèle au plan de l'ouverture qui l'accueille ou à être incliné par rapport à l'ouverture et au joint d'applique.

10. Dispositif de support selon l'une quelconque des revendications précédentes, **caractérisé en ce qu'**il comporte au moins un cadre de guidage (39) formé de préférence par l'association de deux demi-cadres et coopérant avec une ouverture, ledit cadre de guidage comprenant un logement d'accueil (39E) pour loger la partie du joint d'applique (40) destinée à coopérer avec un substrat, ledit logement d'accueil (39E) étant en regard du logement d'accueil (6) du support logeant l'autre partie du joint d'applique destinée à être en contact avec l'élément gonflable (41), de préférence ledit cadre de guidage comprenant des moyens de calage (38) du substrat.

11. Dispositif de support selon l'une quelconque des revendications précédentes, **caractérisé en ce qu'**il est utilisé pour supporter un ou plusieurs substrats, du type plaquettes de silicium, à traiter, en particulier à structurer par voie électrochimique sur au moins l'une de leurs faces plane.

12. Ensemble comprenant le dispositif de support selon l'une quelconque des revendications précédentes et un système de mise sous pression/dépressurisation pneumatique qui est associé à ou aux éléments déformables gonflables (41), en particulier l'ensemble comprenant des moyens de contrôle de la mise en pression ou de dépressurisation pneumatique, des défaillances d'étanchéité et/ou de déformations de substrats détectées pendant le traitement.

## Patentansprüche

1. Haltevorrichtung (1) mit zumindest einem Substrat, das elektrochemisch zu behandeln ist, umfassend:
- Eine Halterung, die zumindest mit einer Queröffnung ausgestattet ist, wobei die Öffnung dazu gedacht ist, ein zu behandelndes Substrat (2) aufzunehmen, und sich ebenübergreifend parallel zur Ebene des zu behandelnde Substrates bzw. der zu behandelnden Substrate erstreckt.
- Mindestens eine Kontaktdichtung (40) in einem Gehäuse (6) der Haltevorrichtung, die sich rund um die Öffnung erstreckt und dazu dient, am Substrat anzuliegen, wenn letzteres in der Öffnung ist,
- Deformierbare, aufblasbare Hilfsmittel, um sicherzustellen, dass die Kontaktdichtung eine Druckkraft in transversaler Richtung auf die Kante des Halterungsrahmens ausübt, und die in Richtung der Öffnung ausgerichtet sind, um die Kontaktdichtung an den Rand des Substrates zu drücken,
**dadurch gekennzeichnet, dass** die deformierbaren, aufblasbaren Hilfsmittel sich von der Kontaktdichtung unterscheiden und aus mindestens einem deformierbaren, aufblasbaren Element (41) bestehen, das um die besagte Kontaktdichtung (40) gegenüber der Öffnung angeordnet ist.

2. Haltevorrichtung nach Anspruch 1, **dadurch gekennzeichnet, dass** sie - vorzugsweise auf derselben Halterung (3) - mehrere Öffnungen (3) enthält, die jeweils dazu vorgesehen sind, ein zu behandelndes Substrat aufzunehmen, wobei jede Öffnung rundherum mit einem Gehäuse (6) ausgestattet ist, welches eine Kontaktdichtung (4) umfasst, um ein Substrat zu bearbeiten, und **dadurch gekennzeichnet, dass** sie mindestens ein deformierbares, aufblasbares Element (41) umfasst, das dazu geeignet ist, mittels Druckausübung rund um jede Kontaktdichtung (40) zu wirken, wobei das aufblasbare Element (41) vorzugsweise ebenfalls in der besagten Halterung positioniert ist (3).

3. Haltevorrichtung nach irgendeinem der vorstehenden Ansprüche, **dadurch gekennzeichnet, dass** eine Öffnung (3) der Halterung einen Rahmen (30) begrenzt, dessen Kante (36) mit einer Rinne (61) ausgestattet ist, in der sich die Kontaktdichtung (40) befindet, wobei die innere Kante der Kontaktdichtung dazu vorgesehen ist, dem Substrat gegenzuhalten, wobei das Profil der geometrischen Form des Umfangs des Substrates entspricht.

4. Haltevorrichtung nach Anspruch 2, **dadurch gekennzeichnet, dass** sie mehrere Öffnungen umfasst, wobei jede mit einer Kontaktdichtung verbunden ist, und **dadurch gekennzeichnet, dass** die Halterung mehrere aufblasbare Elemente umfasst, die jeweils mit einer Kontaktdichtung verbunden sind, oder die ein einziges aufblasbares Element für mehrere Kontaktdichtungen umfasst, dessen Form und Länge so angepasst sind, dass es jede Kontaktdichtung unterbrechungsfrei umgibt.

5. Haltevorrichtung nach einem der vorstehenden Ansprüche, **dadurch gekennzeichnet, dass** die Kontaktdichtung oder jede Kontaktdichtung (40) auf den lateralen Seiten quer zur Kontaktkante der Dichtung Aussparungen (45) aufweist.

6. Haltevorrichtung nach einem der vorstehenden Ansprüche, **dadurch gekennzeichnet, dass** das aufblasbare Element (41) eine Schattenfuge mit einem einzigen geschlossenen Abschnitt ist, ausgestattet mit einer Abluftöffnung, oder mit einer offenen Verbindung mit zwei offenen Enden, dazu geeignet, mit den Hilfsmitteln zum pneumatischen Druckaufbau oder Druckabbau verbunden zu werden.

7. Haltevorrichtung nach einem der vorstehenden Ansprüche, **dadurch gekennzeichnet, dass** das Gehäuse (6) unter anderem das aufblasbare Element (41) enthält, und das besagte Gehäuse Gehäusewände (63, 64) hat, welche die Ausdehnung des aufblasbaren Elementes (41) begrenzen, wobei diese Begrenzungen dazu vorgesehen sind, den Druck auf die Kontaktdichtung (40), die gegenüberliegend positioniert ist, zu begrenzen.

8. Vorrichtung nach dem vorstehenden Anspruch, **dadurch gekennzeichnet, dass** das Gehäuse (6), in dem sich das aufblasbare Element (41) befindet, im Inneren ein größeres Volumen auf der Seite der Kontaktdichtung als auf der gegenüberliegenden Seite hat, sodass sich das aufblasbare Element mehr in Richtung der besagten Kontaktdichtung aufblasen kann und sich die Kontaktdichtung somit mehr in Richtung des Substrates bewegen kann (22).

9. Haltevorrichtung nach einem der vorstehenden Ansprüche, **dadurch gekennzeichnet, dass** sie über Mittel zur Verkeilung (38, 44) verfügt, die dazu vorgesehen sind, das Substrat zu halten, indem mindestens eine Seite des Substrates gegen die besagten Mittel zur Verkeilung gedrückt wird, wobei die besagten Mittel zur Verkeilung vorzugsweise fest mit der Halterung (3) oder der Kontaktdichtung (40) verbunden sind und wobei die Mittel zur Verkeilung eventuell in Bezug auf die Öffnung einstellbar sind und wobei das Substrat dazu vorgesehen ist, perfekt parallel zur Öffnung, in der es aufgenommen wird, positioniert zu sein, oder in Bezug zur Öffnung und der Kontaktdichtung geneigt zu sein.

10. Haltevorrichtung nach einem der vorstehenden Ansprüche, **dadurch gekennzeichnet, dass** sie mindestens einen Führungsrahmen (39) hat, der vorzugsweise mittels Verbindung zweier Halbrahmen geformt wird und mit der Öffnung zusammenarbeitet, wobei der besagte Führungsrahmen ein Gehäuse zur Aufnahme (39E) enthält, um den Teil der Kontaktdichtung (40) aufzunehmen, der dazu vorgesehen ist, mit einem Substrat zusammenzuarbeiten, wobei das besagte Gehäuse zur Aufnahme (39E) gegenüber des Gehäuses (6) der Halterung, in dem sich der andere Teil der Kontaktdichtung, die in Kontakt mit dem aufblasbaren Element stehen soll (41), befindet, liegt, und wobei der besagte Führungsrahmen Mittel zur Vekeilung (38) des Substrates enthält.

11. Haltevorrichtung nach einem der vorstehenden Ansprüche, **dadurch gekennzeichnet, dass** sie verwendet wird, um ein oder mehrere Substrate aufzunehmen, aus Siliziumplättchen, um die Substrate auf mindestens einer ihrer ebenen Flächen elektrochemisch zu behandeln und insbesondere zu strukturieren.

12. Komplex umfassend die Haltevorrichtung gemäß irgendeinem der vorstehenden Ansprüche und ein System zum pneumatischen Druckaufbau/-abbau, das mit einem oder mehreren aufblasbaren Elementen (41) verbunden ist, wobei der Komplex insbesondere Steuerungsmittel umfasst, um den pneumatischen Druckaufbau/-abbau, Störungen bei der Dichtung und/oder Deformationen des Substrates, die während der Behandlung festgestellt werden, zu kontrollieren.

## Claims

1. A substrate holder apparatus with at least one substrate to process electrochemically, comprising:
- a substrate holder with at least one through aperture (37), the aperture being intended to receive a substrate (2) to process, extending in a general plan parallel to the plan of the surface or surfaces to be treated,
- at least one contacting seal (40) lodged in a groove (6) of the holder, extending around the perimeter of the aperture, and destined to contact the substrate when lodged in the aperture,
- some deformable inflatable means allowing the contacting seal to exert compressive strengths in the perpendicular direction of the edge of the holder frame and directed toward the aperture such as to press the contacting seal against the edge of the substrate,
**characterized by** the fact that the deformable inflatable means are distinct from the contacting seal and are made up with at least one deformable inflatable element (41) surrounding the said contacting seal, outside the aperture.

2. A holder apparatus according to claim 1, **characterized by** the fact that it comprises, preferably in the same holder (3), several apertures (37), each one intended to receive one substrate to process, each aperture having one lodge comprising one contacting seal (40) for interacting with a substrate, and **characterized by** the fact that it comprises at least one deformable inflatable element (41) able to interact all around each contacting seal (40) by compression, the inflatable element being lodged preferably in the said holder (3).

3. A holder apparatus according to any of the previous claims, **characterized by** the fact that the holder aperture (37) delineates a frame with an edge including a groove lodging a contacting seal (40), the inner edge of this contacting seal destined to face the substrate following the profile corresponding to the geometrical shape surrounding the substrate.

4. A holder apparatus according to claim 2, **characterized by** the fact that it comprises several apertures, each one associated with one contacting seal, and by the fact that the apparatus comprises several inflatable elements, each one associated with one contacting seal, or by the fact that it comprises a unique inflatable element with a shape and a length suited to run all along each contacting seal.

5. A holder apparatus according to any of the previous claims, **characterized by** the fact that the contacting seal or each contacting seal (40) comprises some recesses (45) on its lateral faces perpendicularly to its contacting edges.

6. A holder apparatus according to any of the previous claims, **characterized by** the fact that the inflatable element (41) is a closed seal with a bore in its cross section, comprising one exhaust orifice, or is a tube with two open extremities, the exhaust orifice or both open extremities having the capability to be connected to pressurization or de-pressurization pneumatic systems.

7. A holder apparatus according to any of the previous claims, **characterized by** the fact that the lodging cavity (6) receives also the inflatable element (41), said lodging cavity comprising walls (63, 64) constituting stopping walls intended to limit the compression exerted on the opposite contacting seal (40).

8. An apparatus according to any of the previous claims, **characterized by** the fact that the lodging cavity (6) receiving the inflatable element (41) leaves space for the contacting seal such as the dilatation of the inflatable element is more important in the direction of the contacting seal, causing the displacement of the contacting seal in the direction of the substrate (22).

9. An apparatus according to any of the previous claims, **characterized by** the fact that it comprises blockage means (38, 44) intended to maintain the substrate by applying at least one face of the substrate against these said blockage means, these said blockage means being preferably a part of the holder (3) or a part of the contacting seal (40), these blockage means being eventually adjustable with respect to the plan of the aperture, the substrate being destined to be parallel with the plan of the receiving aperture or being destined to be tilted with respect to the aperture and the contacting seal.

10. An apparatus according to anyone of the previous claims, **characterized by** the fact that it comprises at least one guiding frame (39) constituted preferentially by the association of two half frames cooperating with the aperture, said guiding frame comprising a housing (39E) for receiving the contacting seal (40) intended to cooperate with a substrate, said housing (39E) facing the housing (6) of the holder receiving the contacting seal intended to be in contact with the inflatable element (41), said guiding frame comprising some substrate blockage means (38) preferentially.

11. An apparatus according to any of the previous claims, **characterized by** the fact that it is used to hold one or several substrates to treat, such as silicon wafers, in particular electrochemically on at least one of their flat surfaces.

12. A whole set of elements comprising the holder apparatus according to any of the previous claims and a pneumatic system of pressurization/depressurization application associated with one or several deformable inflatable elements (41), in particular the whole set comprising controlling means of the application of the pressurization or of the depressurization, of airtight failures and/or of substrate deformations during the treatment.
